# EUROPEAN PATENT APPLICATION

(11) **EP 4 395 512 A1**
(43) Date of publication of application: **03.07.2024**
(21) Application number: 23220717.5
(22) Date of filing: 29.12.2023
(51) Int. Cl.: H10K 59/131, H10K 59/80

(54) **DISPLAY APPARATUS AND VEHICLE INCLUDING DISPLAY APPARATUS**

(30) Priority: 30.12.2022 KR 20220191035
(71) Applicant: Samsung Display Co., Ltd., Yongin-si, Gyeonggi-do 17113 (KR)
(72) Inventor: YOU, Chungi, 17113 Yongin-si (KR)
(74) Representative: Walaski, Jan Filip

(57) **Abstract**

A display apparatus includes: a substrate including: a display area including a plurality of pixels; a pad area at one side of the display area; and an adjacent area between the display area and the pad area; a first connection wire above the substrate in the adjacent area, and to transmit a driving voltage from the pad area to the plurality of pixels in the display area; a first spacer group adjacent to the plurality of pixels in the display area; and a second spacer group above the first connection wire in a supplementary area. The supplementary area is defined within a perimeter of the first connection wire to overlap with the first connection wire in a plan view.

## Description

### CROSS-REFERENCE TO RELATED APPLICATION

This application claims priority to Korean Patent Application No. 10-2022-0191035, filed on December 30, 2022, in the Korean Intellectual Property Office.

### BACKGROUND

### 1. Field

The disclosure relates to a display apparatus and a vehicle including the display apparatus.

### 2. Description of the Related Art

Recently, electronic apparatuses are widely used. Electronic apparatuses include various mobile electronic apparatuses and stationary electronic apparatuses. The electronic apparatuses include display apparatuses that may provide users with visual information, such as images or videos, to support various functions.

Display apparatuses are devices for displaying images by receiving information about the images. Display apparatuses may include a display area, and a peripheral area that is a non-display area. Various layers including wires for supplying data or voltages may be stacked in the peripheral area. In this case, as the various layers may interfere with one another, some of the layers may be delaminated.

The above information disclosed in this Background section is for enhancement of understanding of the background of the present disclosure, and therefore, it may contain information that does not constitute prior art.

### SUMMARY

One or more embodiments of the present disclosure are directed to a display apparatus including a spacer, and a vehicle including the display apparatus.

One or more embodiments of the present disclosure are directed to a display apparatus that may prevent or substantially prevent delamination of various layers, particularly, in a peripheral area, and a vehicle including the display apparatus.

However, the aspects and features of the present disclosure are not limited to those described above.

Additional aspects and features will be set forth, in part, in the description that follows, and in part, will be apparent from the description, or may be learned by practicing one or more of the presented embodiments of the present disclosure.

According to one or more embodiments of the present disclosure, a display apparatus includes: a substrate including: a display area including a plurality of pixels; a pad area at one side of the display area; and an adjacent area between the display area and the pad area; a first connection wire above the substrate in the adjacent area, and configured to transmit a driving voltage from the pad area to the plurality of pixels in the display area; a first spacer group adjacent to the plurality of pixels in the display area; and a second spacer group above the first connection wire in a supplementary area. The supplementary area is defined within a perimeter of the first connection wire to overlap with the first connection wire in a plan view.

In an embodiment, the supplementary area may have as a closed loop shape along the perimeter of the first connection wire in a plan view.

In an embodiment, the supplementary area may extend in a first direction, and may include a plurality of line shapes spaced from each other in a second direction crossing the first direction in a plan view.

In an embodiment, the first connection wire may include: a first wire portion in the adjacent area; and a second wire portion extending from the first wire portion toward the pad area. The supplementary area may be located at a boundary between the first wire portion and the second wire portion in a plan view.

In an embodiment, the display apparatus may further include: an encapsulation substrate covering the display area and the adjacent area; and a sealing member surrounding the display area, and sealing between the substrate and the encapsulation substrate. The supplementary area may be located between one side of the display area and the sealing member in a plan view.

In an embodiment, a distance from the encapsulation substrate to an upper surface of the first spacer group may be the same as a distance from the encapsulation substrate to an upper surface of the second spacer group.

In an embodiment, a distance from an upper surface of the substrate to an upper surface of the first spacer group may be the same as a distance from the upper surface of the substrate to an upper surface of the second spacer group.

In an embodiment, the second spacer group may include a single second spacer covering the supplementary area.

In an embodiment, the second spacer group may include a plurality of second spacers forming a pattern in the supplementary area.

In an embodiment, the first spacer group may include a plurality of first spacers surrounding at least one of the plurality of pixels, and spaced from each other by a first distance, the plurality of second spacers may be spaced from each other by a second distance, and the first distance may be the same as the second distance.

In an embodiment, a size of each of the plurality of first spacers may be the same as a size of each of the plurality of second spacers.

In an embodiment, a shape of each of the plurality of first spacers may be the same as a shape of each of the plurality of second spacers.

In an embodiment, the first spacer group and the second spacer group may include the same material as each other.

In an embodiment, the display apparatus may further include a pixel defining layer covering the substrate in the display area and the adjacent area, and having an opening defining an emission area of a corresponding one of the plurality of pixels, and the first spacer group and the second spacer group may be located on the pixel defining layer.

According to one or more embodiments of the present disclosure, a vehicle includes: a body forming an exterior of the vehicle; and a display apparatus inside the body. The display apparatus includes: a substrate including: a display area including a plurality of pixels; a pad area at one side of the display area; and an adjacent area between the display area and the pad area; a first connection wire above the substrate in the adjacent area, and configured to transmit a driving voltage from the pad area to the plurality of pixels in the display area; a first spacer group adjacent to the plurality of pixels in the display area; and a second spacer group above the first connection wire in a supplementary area. The supplementary area is defined within a perimeter of the first connection wire to overlap with the first connection wire in a plan view.

In an embodiment, the vehicle may further include: a instrument cluster located in front of a steering wheel; a center fascia at one side of the instrument cluster; and a dashboard spaced from the instrument cluster with the center fascia therebetween, and the display apparatus may be located in at least one of the instrument cluster, the center fascia, or the dashboard.

In an embodiment, the supplementary area may have a closed loop shape along the perimeter of the first connection wire in a plan view.

In an embodiment, the supplementary area may extend in a first direction, and may include a plurality of line shapes spaced from each other in a second direction crossing the first direction in a plan view.

In an embodiment, the first connection wire may include: a first wire portion in the adjacent area; and a second wire portion extending from the first wire portion toward the pad area, and the supplementary area may be located at a boundary between the first wire portion and the second wire portion in a plan view.

In an embodiment, the display apparatus may further include: an encapsulation substrate covering the display area and the adjacent area; and a sealing member surrounding the display area, and sealing between the substrate and the encapsulation substrate. The supplementary area may be located between one side of the display area and the sealing member in a plan view.

The above and other aspects and features that are different from those described above will become more apparent from the following detailed description with reference to the drawings, the claims, and their equivalents.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a schematic perspective view of a display apparatus;
FIG. 2 is a schematic cross-sectional view of the display apparatus taken along the line II-II' of FIG. 1;
FIG. 3 is a schematic plan view of a display apparatus;
FIG. 4 is a schematic equivalent circuit diagram of a pixel of a display apparatus;
FIG. 5 is a schematic cross-sectional view of a display apparatus taken along the lines IV-IV' and V-V' of FIG. 3;
FIG. 6 is a schematic plan view of a display apparatus and illustrates an enlarged view of the region VI of FIG. 3;
FIGS. 7-9 are schematic plan views of a supplementary area;
FIG. 10 is a schematic plan view of a first spacer group;
FIG. 11 is a schematic plan view of a second spacer group and illustrates an enlarged view of the region XI of FIG. 6; and
FIGS. 12-15 illustrate various products to which a display apparatus is applied.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

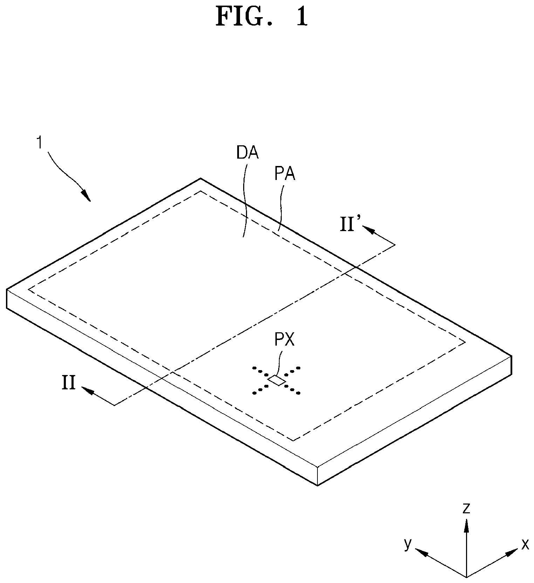

FIG. 1 is a schematic perspective view of a display apparatus 1.

Referring to FIG. 1, the display apparatus 1 may be a device for displaying a video and/or a still image. The display apparatus 1 may be used as a display screen for not only portable electronic devices, such as mobile phones, smart phones, tablet personal computers (PCs), mobile communication terminals, electronic organizers, electronic books, portable multimedia players (PMPs), navigation devices, ultra mobile PCs (UMPCs), and the like, but also for various suitable products, such as televisions, notebook computers, monitors, billboards, internet of things (IOT) devices, and the like. Furthermore, the display apparatus 1 may be used for wearable devices, such as smart watches, watch phones, glasses-type displays, and head mounted displays (HMDs). Furthermore, the display apparatus 1 may be used as an instrument panel of a vehicle, a center information display (CID) disposed in the center fascia or dashboard of a vehicle, a room mirror display in lieu of a side mirror of a vehicle, or a display screen disposed at the rear surface of a front seat of a vehicle as an entertainment device for a passenger in the rear seat of the vehicle.

The display apparatus 1 may display an image. The display apparatus 1 may include a display area DA and a peripheral area PA. A plurality of pixels PX may be arranged in the display area DA. The peripheral area PA may at least partially surround (e.g., around a periphery of) the display area DA. The peripheral area PA may be a non-display area where the pixels PX are not arranged. A pad may be arranged in the peripheral area PA.

Although FIG. 1 illustrates the display apparatus 1 having the display area DA that has a rectangular shape, the display area DA may have a circular shape, an oval shape, or another polygonal shape, such as a triangular shape, a pentagonal shape, and/or the like. Furthermore, while the display apparatus 1 of FIG. 1 is illustrated as a flat plate display apparatus having a flat or substantially flat shape or form, the display apparatus 1 may be implemented in various suitable shapes or forms, such as a flexible display apparatus, a foldable display apparatus, a rollable display apparatus, and/or the like.

The pixels PX may be arranged in the display area DA. The pixels PX may emit light, and the display apparatus 1 may display an image in the display area DA. Each of the pixels PX may include a plurality of sub-pixels. Any one of the plurality of sub-pixels may emit red light, green light, or blue light, or. any one of the plurality of sub-pixels may emit red light, green light, blue light, or white light.

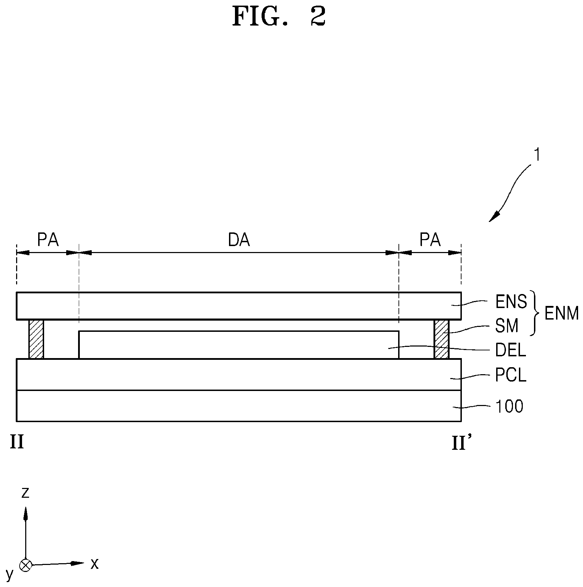

FIG. 2 is a schematic cross-sectional view of the display apparatus 1 taken along the line II-II' of FIG. 1. In FIG. 2, the same reference numerals as those of FIG. 1 are used to denote the same or substantially the same elements as those described above with reference to FIG. 1, and thus, redundant description thereof may not be repeated.

Referring to FIG. 2, the display apparatus 1 may include a substrate 100, a pixel circuit layer PCL, a display element layer DEL, and an encapsulation member ENM. The display apparatus 1 may include the display area DA and the peripheral area PA. The display area DA and the peripheral area PA may be defined in the substrate 100. In other words, the substrate 100 may also include the display area DA and the peripheral area PA.

The substrate 100 may include glass. In another implementation, the substrate 100 may include a polymer resin, such as polyethersulfone, polyarylate, polyetherimide, polyethylene naphthalate, polyethylene terephthalate, polyphenylene sulfide, polyimide, polycarbonate, cellulose triacetate, cellulose acetate propionate, and/or the like. The substrate 100 may have a multilayered structure including a base layer including the polymer resin as described above, and a barrier layer. For convenience, a case in which the substrate 100 includes glass is mainly described in more detail hereinafter, but the present disclosure is not limited thereto.

The pixel circuit layer PCL may be disposed on the substrate 100. The pixel circuit layer PCL may include a pixel circuit, and the pixel circuit may include at least one thin film transistor. The display element layer DEL may be disposed on the pixel circuit layer PCL, and may overlap with the display area DA. The display element layer DEL may include a display element that is driven by a pixel circuit. The display element may be an organic light-emitting diode (OLED) including an organic emission layer. As another example, the display element may be a light-emitting diode (LED) including an inorganic emission layer. The size of the light-emitting diode LED may be a micro scale or a nano scale. For example, the light-emitting diode LED may be a micro light-emitting diode. As another example, the light-emitting diode may be a nanorod light-emitting diode. The nanorod light-emitting diode may include gallium nitride (GaN). A color conversion layer may be disposed on the nanorod light-emitting diode. The color conversion layer may include quantum dots. As another example, the display element may be a quantum-dot light-emitting diode including a quantum-dot emission layer.

The encapsulation member ENM may be arranged to cover the display element layer DEL. The encapsulation member ENM may include an encapsulation substrate ENS and a sealing member SM. The encapsulation substrate ENS may be disposed above the display element layer DEL, and in other words, the display element layer DEL may be arranged between the substrate 100 and the encapsulation substrate ENS. The encapsulation substrate ENS may include glass.

The sealing member SM may be arranged in the peripheral area PA to surround (e.g., around a periphery of) the display area DA in a plan view. The sealing member SM may be arranged between the substrate 100 and the encapsulation substrate ENS. Accordingly, the sealing member SM may seal an inner space between the substrate 100 and the encapsulation substrate ENS. An absorbent and/or a filler may be arranged in the inner space between the substrate 100 and the encapsulation substrate ENS.

The sealing member SM may be a sealant. The sealing member SM may include a suitable material that is cured by laser. For example, the sealing member SM may be frit. In more detail, the sealing member SM may include an organic sealant, such as a urethane-based resin, an epoxy-based resin, and/or an acrylic-based resin, or may include an inorganic sealant. As a urethane-based resin, for example, urethane acrylate and/or the like may be used. As an acrylic-based resin, for example, butylacrylate, ethylhexyl acrylate, and/or the like may be used. The sealing member SM may include silicone. The sealing member SM may include a suitable material that is cured by heat.

However, the present disclosure is not limited thereto, and instead of the encapsulation substrate ENS, an encapsulation layer may be arranged above the display element layer DEL. The encapsulation layer may include at least one inorganic encapsulation layer and at least one organic encapsulation layer, both covering the display element layer DEL. At least one inorganic encapsulation layer and at least one organic encapsulation layer may be alternately stacked. The inorganic encapsulation layer may include one or more inorganic materials from among aluminum oxide (Al₂O₃), titanium oxide (TiOz), tantalum oxide (Ta₂O₅), zinc oxide (ZnOx), silicon oxide (SiO₂), silicon nitride (SiNₓ), and silicon oxynitride (SiON). ZnOx may be a zinc oxide (ZnO) and/or a zinc peroxide (ZnO2). The organic encapsulation layer may include a polymer-based material. The polymer-based material may include an acrylic-based resin, an epoxy-based resin, polyimide, polyethylene, and/or the like. The organic encapsulation layer may include acrylate.

For convenience, a case in which the encapsulation substrate ENS is arranged above the display element layer DEL is mainly described in more detail hereinafter, but the present disclosure is not limited thereto.

A touch sensor layer may be further disposed on the encapsulation substrate ENS. The touch sensor layer may obtain coordinate information according to an external input, for example, such as a touch event.

An optical functional layer may be further disposed on the touch sensor layer. The optical functional layer may reduce a reflectance of light (e.g., external light) input toward the display apparatus 1. The optical functional layer may include a retarder and/or a polarizer. The retarder may be of a film type or a liquid crystal coating type, and may include a λ/2 retarder and/or a λ/4 retarder. The polarizer may also be of a film type or a liquid crystal coating type. The film type may include a stretchable synthetic resin film, and the liquid crystal coating type may include liquid crystals arranged in a suitable pattern (e.g., a certain or predetermined pattern). The retarder and the polarizer may further include a protection film.

The optical functional layer may include a black matrix and color filters. The color filters may be arranged considering the color of light emitted from the display element of the display apparatus 1. Each of the color filters may include a red, green, or blue pigment or dye. As another example, each of the color filters may further include quantum dots, in addition to the pigment or dye. As another example, some of the color filters may not include the pigment or dye, and may include scattering particles such as titanium oxide.

The optical functional layer may have a destructive interference structure. The destructive interference structure may include a first reflective layer and a second reflective layer, which are disposed at (e.g., in or on) different layers from each other. First reflected light and second reflected light reflected from the first reflective layer and the second reflective layer, respectively, may destructively interfere with each other, and accordingly, the reflectance of the external light may be reduced.

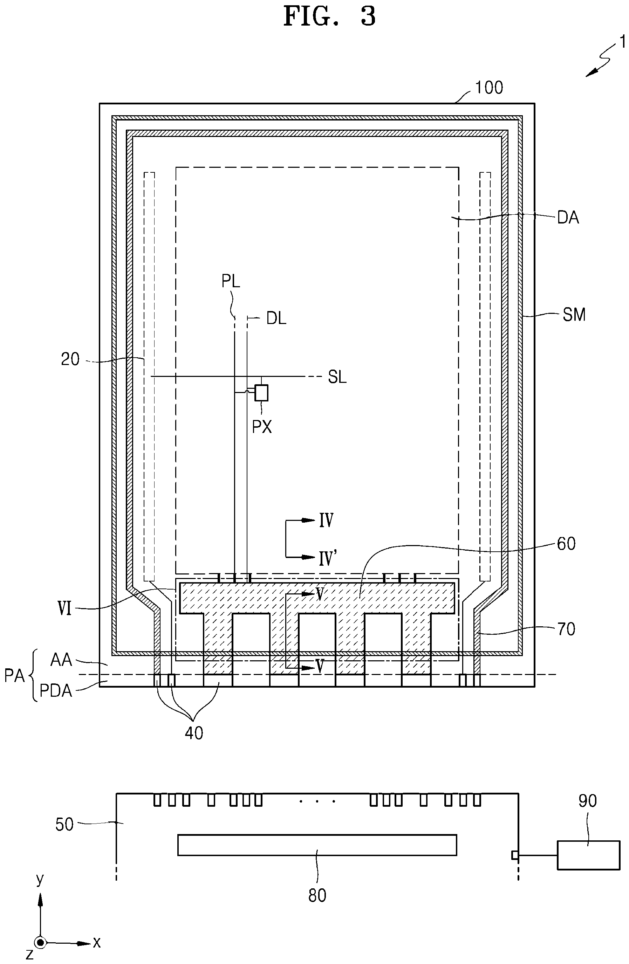

FIG. 3 is a schematic plan view of the display apparatus 1. For convenience of illustration, FIG. 3 illustrates some of the constituent elements of the display apparatus 1.

Referring to FIG. 3, the display apparatus 1 may include the display area DA, and the peripheral area PA at least partially surrounding (e.g., around a periphery of) the display area DA.

The display area DA may provide an image through light emitted from the pixels PX. The pixels PX may be arranged in the display area DA. Each pixel PX may emit, for example, red, green, blue, or white light. Each pixel PX may include a display element, and the display element may include an organic light-emitting device (e.g., an OLED). As used in the present specification, the pixel PX refers to a pixel that emits light of any one of red, green, blue, or white as described above.

The pixel PX may be electrically connected to a scan line SL for transmitting a scan signal, and a data line DL for transmitting a data signal. The pixel PX may receive the scan signal and the data signal, and may emit light.

The peripheral area PA, as a non-display area, may include an adjacent area AA that is adjacent to the display area DA, and a pad area PDA connected to (e.g., extending from) one side of the adjacent area AA.

A drive circuit, for example, such as a scan drive circuit 20, a first connection wire 60, and a second connection wire 70 may be arranged in the peripheral area PA, for example, such as in the adjacent area AA.

The scan drive circuit 20 may be arranged in the adjacent area AA of the substrate 100, and may generate and transmit a scan signal to each pixel PX through a corresponding scan line SL. The scan drive circuit 20 may be arranged in each of the left and right sides of the display area DA, but the present disclosure is not limited thereto. The scan drive circuit 20 may include only one scan drive circuit.

The first connection wire 60 may be arranged in the adjacent area AA. For example, the first connection wire 60 may be arranged at one side of the adjacent area AA that is adjacent to the pad area PDA. In other words, the first connection wire 60 may be arranged between one side of the display area DA and the pad area PDA. The first connection wire 60 may be a drive power supply wire. The first connection wire 60 may be configured to provide a driving power, provided through a pad 40 of the pad area PDA, to each of the pixels PX through a corresponding voltage line, for example, such as a drive voltage line PL.

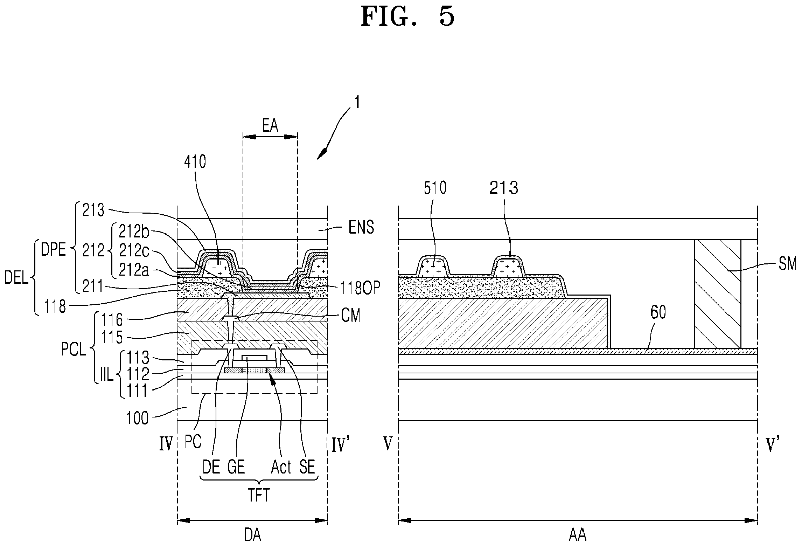

The second connection wire 70 may be arranged in the adjacent area AA, and may at least partially surround (e.g., around a periphery of) the display area DA. For example, the second connection wire 70 may extend along an edge of the substrate 100, and may form a loop having one open side at a side of the display area DA adjacent to the pad area PDA. The second connection wire 70 may be a common power supply wire. The second connection wire 70 may be configured to provide a common power, provided through the pad 40, to a counter electrode 213 (e.g., see FIG. 5) of the pixel PX.

The pad area PDA may be arranged at one side of the adjacent area AA. The pad area PDA may be arranged at the edge of the substrate 100. The pad 40 may include a plurality of pads 40, and the pads 40 may be arranged in the pad area PDA. The pad 40 may be arranged in one end portion of the substrate 100, and may include the plurality of pads 40. The pad 40 may be exposed without being covered by an insulating layer, and may be electrically connected to a display circuit board 50. The pad 40 may be arranged at one side of the substrate 100 where the scan drive circuit 20 is not located.

The display circuit board 50 may electrically connect a control unit (e.g., a controller) 90 with the pad 40, and a signal or power received from the control unit 90 may be transferred through various wires connected to the pad 40. The display circuit board 50 may be a flexible printed circuit board (FPCB). However, the present disclosure is not limited thereto, and the display circuit board 50 may be a rigid printed circuit board (PCB) that is rigid so as not to be bent easily, or may be a composite PCB including both the rigid PCB and the FPCB.

The control unit 90 may receive a vertical sync signal, a horizontal sync signal, and a clock signal, and may generate a control signal to control driving of the scan drive circuit 20. The generated control signal may be transmitted to the scan drive circuit 20 through the pad 40 connected to the display circuit board 50. A scan signal of the scan drive circuit 20 may be provided to each pixel PX through the corresponding scan line SL. The control unit 90 may provide a driving power and a common power to the first connection wire 60 and the second connection wire 70 through the pad 40 connected to the display circuit board 50. The driving power may be provided to each pixel PX, and the common power may be provided to the counter electrode 213 of the pixel PX. , the control unit 90 may be implemented as an integrated circuit (IC), but the present disclosure is not limited thereto.

A data drive circuit 80 may be arranged on the display circuit board 50. The data drive circuit 80 may provide a data signal to each pixel PX. The data signal of the data drive circuit 80 may be provided to each pixel PX through the pad 40 and a corresponding data line DL. For convenience of illustration, the data drive circuit 80 is illustrated as being arranged on the display circuit board 50, but the present disclosure is not limited thereto, and the data drive circuit 80 may be arranged in the peripheral area PA of the substrate 100.

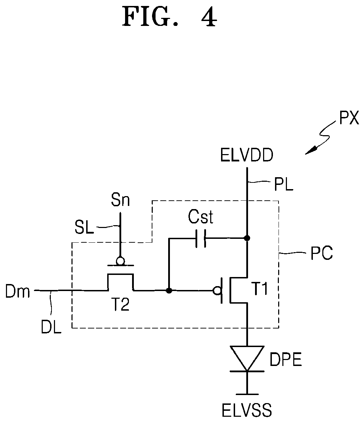

FIG. 4 is a schematic equivalent circuit diagram of the pixel PX of the display apparatus 1.

Referring to FIG. 4, the pixel PX may include a pixel circuit PC, and a display element DPE electrically connected to the pixel circuit PC. The pixel circuit PC may include a driving thin film transistor T1, a switching thin film transistor T2, and a storage capacitor Cst. The pixel PX may emit, for example, red, green, or blue light, or red, green, blue, or white light, through the display element DPE.

The switching thin film transistor T2 is connected to the scan line SL and the data line DL, and may be configured to transmit a data voltage or a data signal Dm input through the data line DL to the driving thin film transistor T1 in response to a scan voltage or a scan signal Sn input through the scan line SL.

The storage capacitor Cst is connected to the switching thin film transistor T2 and the drive voltage line PL, and may store a voltage corresponding to a difference between a voltage received from the switching thin film transistor T2 and a driving voltage ELVDD supplied through the drive voltage line PL.

The driving thin film transistor T1 is connected to the drive voltage line PL and the storage capacitor Cst, and may control a drive current flowing in the display element DPE from the drive voltage line PL in response to a voltage value stored in the storage capacitor Cst. The display element DPE may emit light having a desired luminance (e.g., a certain or predetermined luminance) by the drive current. The counter electrode of the display element DPE may receive a common voltage ELVSS.

Although FIG. 4 illustrates that the pixel circuit PC includes two thin film transistors and one storage capacitor, the present disclosure is not limited thereto. The pixel circuit PC may include seven (7) thin film transistors and one storage capacitor. The pixel circuit PC may include two or more storage capacitors.

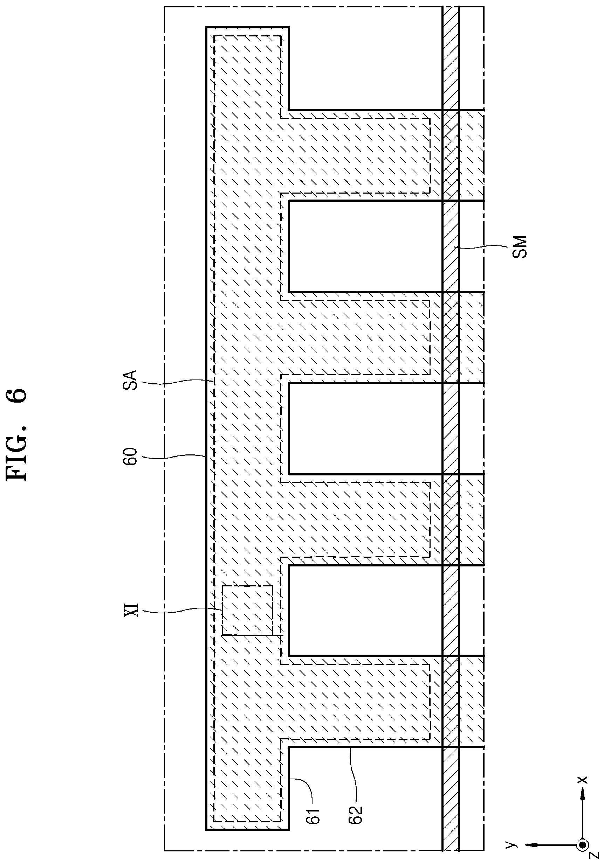

FIG. 5 is a schematic cross-sectional view of the display apparatus 1 taken along the lines IV-IV' and V-V' of FIG. 3. FIG. 6 is a schematic plan view of the display apparatus 1 and illustrates an enlarged view of the region VI of FIG. 3. In FIGS. 5 and 6, the same reference numerals as those described above denote the same or substantially the same elements, and thus, redundant description thereof may not be repeated.

Referring to FIGS. 5 and 6, the display apparatus 1 may include the substrate 100, the pixel circuit layer PCL, the display element layer DEL, and the encapsulation member ENM. Furthermore, as described above, the display apparatus 1 may include the display area DA and the peripheral area PA.

The stack structure of the display apparatus 1 in the display area DA is illustrated in more detail in FIG. 5. The substrate 100 may include the display area DA and the peripheral area PA.

The pixel circuit layer PCL, the display element layer DEL, and the encapsulation member ENM may be sequentially arranged on the substrate 100 in the display area DA.

The pixel circuit layer PCL may include an inorganic insulating layer IIL, a first insulating layer 115, a second insulating layer 116, and the pixel circuit PC. The inorganic insulating layer IIL may include a buffer layer 111, a first gate insulating layer 112, and an interlayer insulating layer 113. The pixel circuit PC may include a thin film transistor TFT.

The buffer layer 111 may be disposed on the substrate 100. The buffer layer 111 may include an inorganic insulating material, such as SiNₓ, SiON, and/or SiOz, and may be a single layer or multilayers including one or more of the inorganic insulating materials described above.

The thin film transistor TFT may include a semiconductor layer Act, and the semiconductor layer Act may be disposed on the buffer layer 111. The semiconductor layer Act may include polysilicon. As another example, the semiconductor layer Act may include amorphous silicon, an oxide semiconductor, an organic semiconductor, and/or the like. The semiconductor layer Act may include a channel region, and a drain region and a source region arranged in opposite sides of the channel region. A gate electrode GE may overlap with the channel region.

The gate electrode GE may include a low-resistance metal material. The gate electrode GE may include a conductive material including molybdenum (Mo), aluminum (Al), copper (Cu), titanium (Ti), and/or the like, and may be formed in a multilayered structure or a single layer including one or more of the materials described above.

The first gate insulating layer 112 may be arranged between the semiconductor layer Act and the gate electrode GE, and may include an inorganic insulating material, such as SiO₂, SiNₓ, SiON, Al₂O₃, TiO₂, Ta₂O₅, hafnium oxide (HfO₂), ZnO, or the like.

The interlayer insulating layer 113 may cover the gate electrode GE. The interlayer insulating layer 113 may include an inorganic insulating material, such as SiOz, SiNₓ, SiON, Al₂O₃, TiO₂, Ta₂O₅, HfO₂, ZnO, or the like, similarly to the first gate insulating layer 112.

A storage capacitor and the thin film transistor TFT may overlap with each other. In this case, an upper electrode of the storage capacitor may be disposed above the gate electrode GE to overlap with the gate electrode GE. The upper electrode may include Al, platinum (Pt), palladium (Pd), silver (Ag), magnesium (Mg), gold (Au), nickel (Ni), neodymium (Nd), iridium (Ir), chromium (Cr), calcium (Ca), Mo, Ti, tungsten (W), and/or Cu, and may be a single layer or multilayers including one or more of the materials described above.

A drain electrode DE and a source electrode SE may each be located on the interlayer insulating layer 113. The drain electrode DE and the source electrode SE may each include a suitable material exhibiting superior conductivity. The drain electrode DE and the source electrode SE may each include a conductive material including Mo, Al, Cu, Ti, and/or the like, and may be formed in a multilayered structure or a single layer including one or more of the materials described above. The drain electrode DE and the source electrode SE may each have a multilayered structure of Ti/Al/Ti.

The first insulating layer 115 may be arranged to cover the drain electrode DE and the source electrode SE. The first insulating layer 115 may include an organic insulating layer. The first insulating layer 115 may include an organic insulating material, such as a general purpose polymer, such as polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and/or suitable blends thereof.

A connection electrode CM may be arranged on the first insulating layer 115. In this case, the connection electrode CM may be connected to the drain electrode DE or the source electrode SE through a contact hole of (e.g., penetrating) the first insulating layer 115. The connection electrode CM may include a suitable material exhibiting superior conductivity. The connection electrode CM may include a conductive material including Mo, Al, Cu, Ti, and/or the like, and may be formed in a multilayered structure or a single layer including one or more of the materials described above. The connection electrode CM may have a multilayered structure of Ti/Al/Ti.

The second insulating layer 116 may be arranged to cover the connection electrode CM. The second insulating layer 116 may include an organic insulating layer. The second insulating layer 116 may include an organic insulating material, such as a general purpose polymer, such as PMMA or PS, a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and/or suitable blends thereof.

The display element layer DEL may be disposed on the pixel circuit layer PCL. The display element layer DEL may include the display element DPE and a pixel defining layer 118. The display element DPE may be an OLED. The display element DPE may include a pixel electrode 211, an intermediate layer 212, and a counter electrode 213.

The display element DPE may be disposed on the second insulating layer 116. The display element DPE may emit red, green, or blue light, or red, green, blue, or white light.

The pixel electrode 211 may be disposed on the second insulating layer 116. The pixel electrode 211 may be electrically connected to the connection electrode CM through a contact hole of (e.g., penetrating) the second insulating layer 116. The pixel electrode 211 may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). The pixel electrode 211 may include a reflective film including Ag, Mg, Al, Pt, Pd, Au, Ni, Nd, Ir, Cr, or a suitable compound thereof. The pixel electrode 211 may further include a film formed of ITO, IZO, ZnO, or In₂O₃ above/below the reflective film. For example, the pixel electrode 211 may have a multilayered structure of ITO/Ag/ITO.

The pixel defining layer 118 may have an opening 118OP for exposing a central portion of the pixel electrode 211, and may be disposed on the pixel electrode 211. The pixel defining layer 118 may include an organic insulating material and/or an inorganic insulating material. The opening 118OP may define an emission area EA for the light emitted from the OLED. For example, the width of the opening 118OP may correspond to the width of the emission area EA.

A first spacer 410 may be disposed on the pixel defining layer 118. The first spacer 410 may be arranged to be adjacent to a pixel. In more detail, the first spacer 410 may be arranged around the opening 1180P of the pixel defining layer 118 adjacent thereto. The first spacer 410 may include a plurality of first spacers, and the first spacers 410 may be arranged to be spaced apart from each other along the periphery (e.g., the circumference) of the opening 1180P. The pixel may include a plurality of pixels, and the opening 1180P of the pixel defining layer 118 may include a plurality of openings. As such, the first spacers 410 around the opening 1180P of the pixel defining layer 118 may form a first spacer group. The first spacer group may be arranged in the entire display area DA.

The first spacer 410 may include an organic insulating material such as polyimide. As another example, the first spacer 410 may include an inorganic insulating material, such as SiNₓ or SiOz, or an organic insulating material and an inorganic insulating material.

The first spacer 410 may include a material different from the material of the pixel defining layer 118. As another example, the first spacer 410 may include the same material as that of the pixel defining layer 118. In this case, the pixel defining layer 118 and the first spacer 410 may be formed in a mask process using a half tone mask and/or the like.

The intermediate layer 212 may be disposed on the pixel defining layer 118. The intermediate layer 212 may include an emission layer 212b disposed in the opening 1180P of the pixel defining layer 118. The emission layer 212b may include a polymer or a low-molecular weight organic material for emitting light of a desired color (e.g., a certain or predetermined color).

A first functional layer 212a and a second functional layer 212c may be respectively disposed below and above the emission layer 212b. The first functional layer 212a may include, for example, a hole transport layer (HTL), or the HTL and a hole injection layer (HIL). The second functional layer 212c is a constituent element disposed on the emission layer 212b, and is optional. The second functional layer 212c may include an electron transport layer (ETL) and/or an electron injection layer (EIL). The first functional layer 212a and/or the second functional layer 212c may be common layers that are formed to entirely cover the substrate 100, similar to the counter electrode 213 described in more detail below.

The counter electrode 213 may include a conductive material having a low work function. For example, the counter electrode 213 may include a (semi-)transparent layer including Ag, Mg, Al, Pt, Pd, Au, Ni, Nd, Ir, Cr, lithium (Li), Ca, a suitable alloy thereof, and/or the like. As another example, the counter electrode 213 may further include a layer such as ITO, IZO, ZnO, or In₂O₃ on the (semi-)transparent layer including one or more of the materials described above.

A capping layer may be further disposed on the counter electrode 213. The capping layer may include LiF, an inorganic material, and/or an organic material.

The encapsulation member ENM may be disposed on the display element layer DEL. In more detail, the encapsulation substrate ENS may be disposed above the counter electrode 213. The encapsulation substrate ENS may be arranged to entirely cover the display area DA and the peripheral area PA. In this case, the sealing member SM may be arranged in the peripheral area PA to surround (e.g., around a periphery of) the display area DA. The sealing member SM may be arranged between the substrate 100 and the encapsulation substrate ENS to seal a space between the substrate 100 and the encapsulation substrate ENS. An absorbent and/or a filler may be arranged in the space (e.g., the inner space) between the substrate 100 and the encapsulation substrate ENS.

As described above, the touch sensor layer may be further disposed on the encapsulation substrate ENS. The optical functional layer may be further disposed on the touch sensor layer. A cover window for protecting the substrate 100, the pixel circuit layer PCL, and the display element layer DEL may be further arranged on the optical functional layer.

Hereinafter, the stack structure of the display apparatus 1 in the peripheral area PA is described in more detail. As the same reference numerals as those described above are used to denote the same or substantially the same elements, redundant description thereof may not be repeated.

The inorganic insulating layer IIL may be disposed on the substrate 100.

The second insulating layer 116 may be disposed on the inorganic insulating layer IIL, for example, such as on the interlayer insulating layer 113. In another implementation, similarly to the display area DA, the first insulating layer 115 may be further arranged between the second insulating layer 116 and the inorganic insulating layer IIL.

A connection wire, for example, such as the first connection wire 60, may be arranged between the inorganic insulating layer IIL and the second insulating layer 116. The first connection wire 60 may extend from the display area DA to the pad area PDA as illustrated in FIG. 3. The first connection wire 60 may be coplanar with the connection electrode CM, and may include the same material as that of the connection electrode CM. In other words, the first connection wire 60 may be formed in the same process as that of the connection electrode CM.

The pixel defining layer 118 may be disposed on the second insulating layer 116.

A second spacer 510 may be disposed on the pixel defining layer 118. The second spacer 510 may be arranged to overlap with the first connection wire 60 in a plan view. The second spacer 510 may include a plurality of second spacers, and the second spacers 510 may form a second spacer group. The second spacer group may be arranged in a supplementary area SA (supplementary area SA) defined in the adjacent area AA. The second spacer 510 may include the same material as that of the first spacer 410. Furthermore, the second spacer 510 may be formed in the same process as that of the first spacer 410.

A distance (e.g., a minimum distance) from the substrate 100 to an upper surface of the first spacer 410 may be the same or substantially the same as a distance (e.g., a minimum distance) from the substrate 100 to an upper surface of the second spacer 510. In other words, a distance (e.g., a minimum distance) from the encapsulation substrate ENS to the upper surface of the first spacer 410 may be the same or substantially the same as a distance (e.g., a minimum distance) from the encapsulation substrate ENS to the upper surface of the second spacer 510. Accordingly, as the distance between the first spacer 410 and the encapsulation substrate ENS and the second spacer 510 and the encapsulation substrate ENS is formed to be constant or substantially constant, the layers under the encapsulation substrate ENS may be prevented or substantially prevented from being excessively pressed by the encapsulation substrate ENS in certain or specific areas of the display area DA and the peripheral area PA.

The counter electrode 213 may be disposed on the pixel defining layer 118. The counter electrode 213 may be arranged to cover the pixel defining layer 118 and the second spacer 510.

The encapsulation substrate ENS may be disposed on the counter electrode 213. The encapsulation substrate ENS may be arranged to entirely cover the display area DA and the peripheral area PA. In this case, in the peripheral area PA, the sealing member SM may be arranged to surround (e.g., around a periphery of) the display area DA. The sealing member SM may be arranged between the substrate 100 and the encapsulation substrate ENS, and may seal a space between the substrate 100 and the encapsulation substrate ENS. An absorbent and/or a filler may be arranged in the space (e.g., the inner space) between the substrate 100 and the encapsulation substrate ENS.

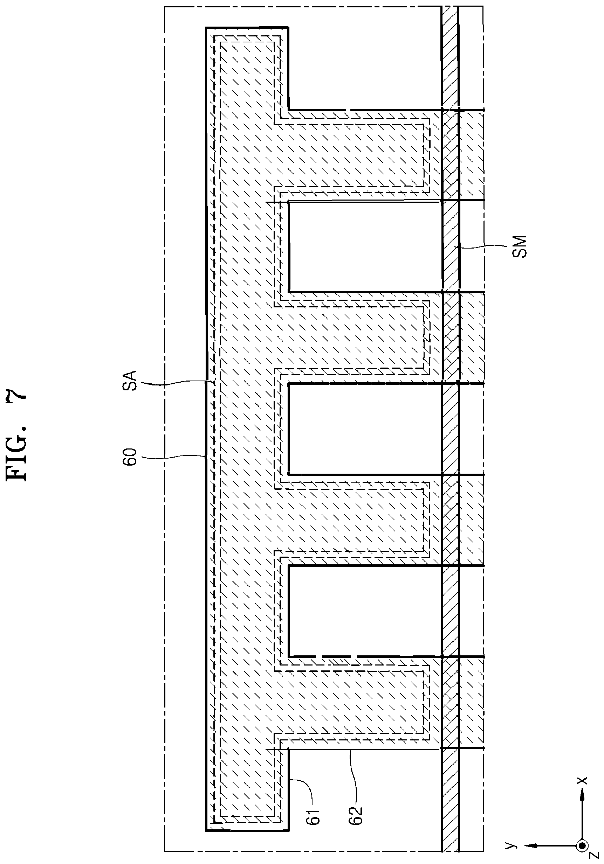

FIGS. 7 through 9 are schematic plan views of the supplementary area SA.

Referring to FIGS. 6 and 7 through 9, the first connection wire 60 may be arranged in the adjacent area AA as illustrated in FIG. 3, and may be located between the display area DA and the pad area PDA in a plan view. The first connection wire 60 may include a first wire portion 61 and a second wire portion 62. The first wire portion 61 may be a portion extending in a first direction (e.g., the x direction). The first wire portion 61 may extend in the first direction between one end portion of the substrate 100 and another end portion of the substrate 100 opposite to the one end portion. The first wire portion 61 may extend in a direction parallel to or substantially parallel to one side of the display area DA and/or one side of the substrate 100. The first wire portion 61 may be electrically connected to the display area DA through various wires, such as a voltage line.

The second wire portion 62 may be a portion that extends in a second direction (e.g., the y direction) crossing (e.g., intersecting) the first direction. The second wire portion 62 may extend from the first wire portion 61 in the second direction, and for example, the second wire portion 62 may extend perpendicularly or substantially perpendicularly from the first wire portion 61. The second wire portion 62 may extend from the first wire portion 61 to the pad area PDA. The second wire portion 62 may be electrically connected to the pads 40 in the pad area PDA.

The first wire portion 61 may be integrally formed, but the present disclosure is not limited thereto, and the first wire portion 61 may be formed in a plurality of separate forms (e.g., a plurality of separate portions). Furthermore, the second wire portion 62 may include a plurality of second wire portions, and the second wire portions 62 may each extend from the first wire portion 61. For convenience, as illustrated in FIGS. 3 and 6, a case in which the first wire portion 61 is integrally formed and the second wire portion 62 includes four second wire portions is mainly described in more detail hereinafter, but the present disclosure is not limited thereto.

The supplementary area SA may be defined within the perimeter of the first connection wire 60 to overlap with the first connection wire 60 in a plan view. The supplementary area SA may be defined as an area in which the second spacer group is arranged. During the manufacturing process of a display apparatus of a comparative example having no second spacer group, as the encapsulation substrate ENS is pressed, the pixel defining layer 118 and the counter electrode 213 above the pixel defining layer 118 may be strongly pressed so that the counter electrode 213 may be partially delaminated. This may cause a difference in transmittance of light reflected in the first connection wire 60, and the difference in the transmittance of light may be recognized by a user. The second spacer group may be provided as described above, and may prevent or substantially prevent the delamination of a layer such as the counter electrode 213, because the second spacer 510 may prevent or substantially prevent the encapsulation substrate ENS above the first connection wire 60 from strongly contacting the pixel defining layer 118 and/or the counter electrode 213 above the pixel defining layer 118. Accordingly, a surface that may be uniformly recognized is provided, so that user aesthetics may be improved.

Referring to FIGS. 6 through 9, the supplementary area SA may be defined to have various suitable shapes above the first connection wire 60. As illustrated in FIG. 6, the supplementary area SA may be defined as completely or substantially completely overlapping with the first connection wire 60 within the perimeter of the first connection wire 60 in a plan view. In other words, the second spacer group arranged in the supplementary area SA may completely or substantially completely cover the first wire portion 61 and the second wire portion 62.

Furthermore, the supplementary area SA may be defined between the display area DA and the sealing member SM. In more detail, the supplementary area SA may be defined between one side of the display area DA and the sealing member SM.

As another example, as illustrated in FIG. 7, the supplementary area SA may be defined as having a closed loop shape along the perimeter of the first connection wire 60. The supplementary area SA may be defined as having a shape with an empty inner space while extending along the perimeter of the first connection wire 60, and thus, the second spacer group may be arranged along the perimeter of the first connection wire 60, while not being arranged inside a portion within the perimeter of the first connection wire 60.

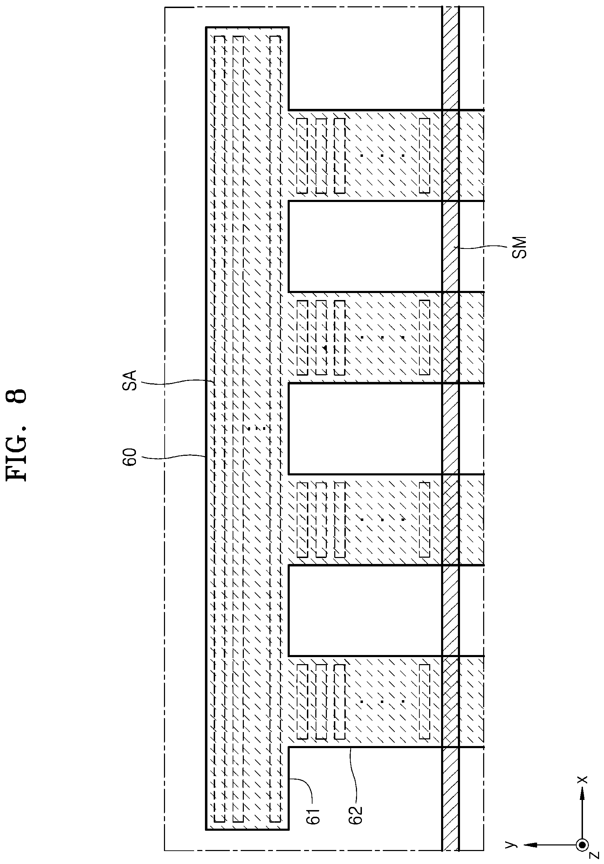

As illustrated in FIG. 8, the supplementary area SA may be defined in the form of a plurality of lines. For example, the supplementary area SA may be defined in the form of a plurality of lines extending in the first direction that is the same or substantially the same as the extension direction of the first wire portion 61. Accordingly, the supplementary area SA may include, in the first wire portion 61, one or more lines extending in the first direction, and spaced apart from each other in the second direction. Furthermore, the supplementary area SA may include, in the second wire portion 62, one or more lines extending in the first direction, and spaced apart from each other in the second direction. However, the present disclosure is not limited thereto, and it will be understood that the supplementary area SA may be defined in the form of a plurality of lines extending in the second direction, and spaced apart from each other in the first direction. Furthermore, a plurality of lines extending in one direction are not limited to the form of a straight line, and may be defined in the form of a zigzag or a curve.

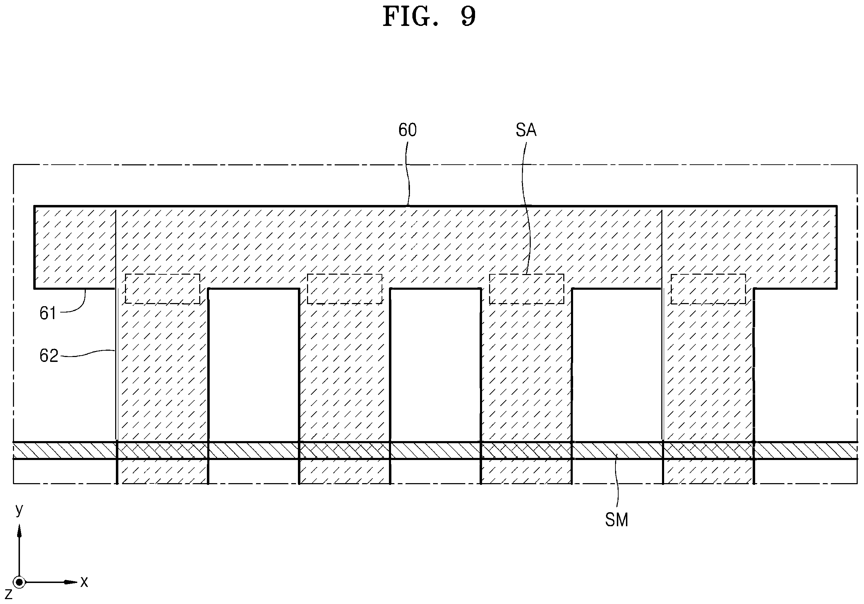

As illustrated in FIG. 9, the supplementary area SA may be defined at a boundary between the first wire portion 61 and the second wire portion 62. In this case, the supplementary area SA may be defined as having a suitable shape, such as a polygon (e.g., a rectangle), a circle, an oval, and/or the like. The boundary between first wire portion 61 and the second wire portion 62 may be an area where the case of the encapsulation substrate ENS strongly contacting the pixel defining layer 118 and/or the counter electrode 213 often occurs. Accordingly, the delamination of the counter electrode 213 due to contact with the encapsulation substrate ENS may be reduced.

The second spacer group may be configured by the second spacer 510 of a single piece covering the supplementary area SA illustrated in FIGS. 6 to 9. For example, in FIG. 6, the second spacer group may be configured by a single second spacer 510 that entirely covers the supplementary area SA. In FIG. 7, the second spacer group may be configured by a single second spacer 510 that entirely covers the supplementary area SA in the form of a closed loop. In FIGS. 8 and 9, the second spacer group may be configured by a plurality of single second spacers 510, each covering a corresponding one of a plurality of supplementary areas of the supplementary area SA.

The second spacer group may be configured by the second spacer 510 that includes a plurality of second spacers forming a pattern in the supplementary area SA, for example, as illustrated in FIG. 5. This will be described in more detail below.

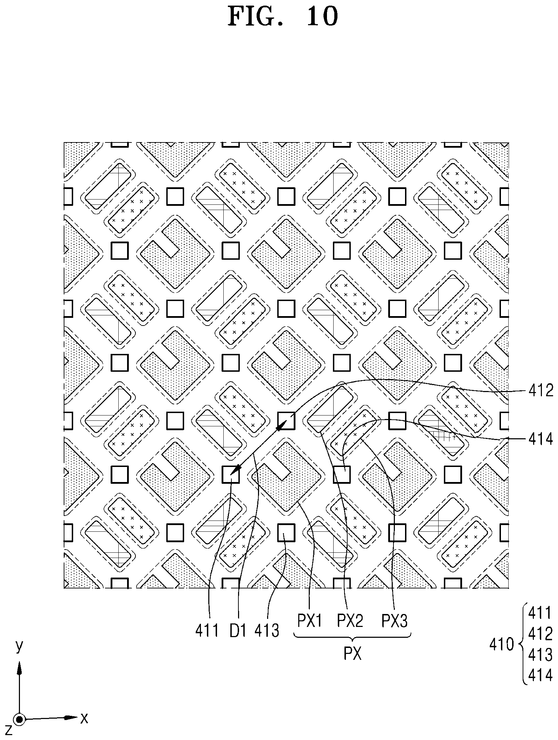

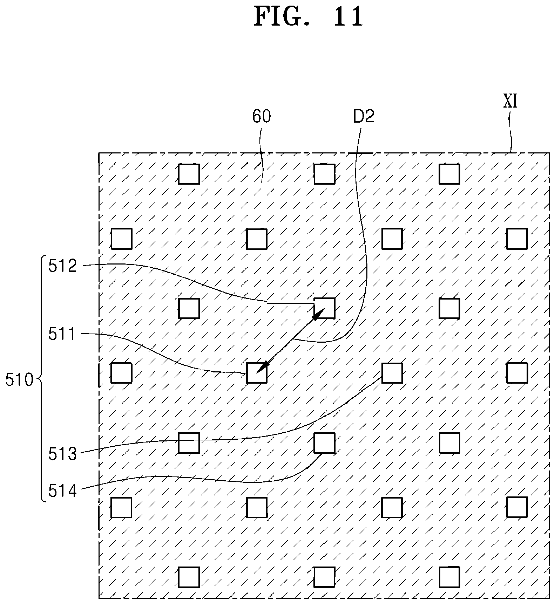

FIG. 10 is a schematic plan view of the first spacer group. FIG. 11 is a schematic plan view of the second spacer group and illustrates an enlarged view of the region XI of FIG. 6.

Referring to FIG. 10, the display apparatus 1 may include the pixels PX arranged in the display area DA. The pixels PX may include a first pixel PX1, a second pixel PX2, and a third pixel PX3. The first pixel PX1, the second pixel PX2, and the third pixel PX3 may be pixels for emitting light of different colors from each other. For example, the first pixel PX1 may be a pixel for emitting blue light, the second pixel PX2 may be a pixel for emitting red light, and the third pixel PX3 may be a pixel for emitting green light. Blue light may belong to a wavelength band of 400 nm to 495 nm, red light may belong to a wavelength band of 580 nm to 780 nm, and green light may belong to a wavelength band of 495 nm to 580 nm. The present disclosure is not limited to the arrangement of the pixels PX illustrated in FIG. 10. The pixels PX may be arranged in various suitable methods or forms, such as a stripe method or form or a diamond method or form (e.g., a PENTILE^{®} method or form, PENTILE^{®} being a duly registered trademark of Samsung Display Co., Ltd.).

Each of the pixels PX may include the display element DPE as illustrated in FIG. 5. The first spacer group arranged in the display area DA may include the first spacers 410 adjacent to the pixels PX. The first spacers 410 may be arranged to surround (e.g., around a periphery of) any one of the pixels PX. For example, the first spacers 410 may surround (e.g., around a periphery of) the first pixel PX1. The first spacers 410 may include a first-1 spacer 411, a first-2 spacer 412, a first-3 spacer 413, and a first-4 spacer 414. The first-1 spacer 411, the first-2 spacer 412, the first-3 spacer 413, and the first-4 spacer 414 may surround (e.g., around a periphery of) the first pixel PX1, and may be arranged to be spaced apart from each other by a first distance D1. Although FIG. 10 illustrates that the distances between the first-1 spacer 411 to the first-4 spacer 414 are all the same or substantially the same as the first distance D1, the present disclosure is not limited thereto, and for example, the distance between the first-1 spacer 411 and the first-2 spacer 412 may be different from the distance between the first-2 spacer 412 and the first-3 spacer 413. For convenience, a case in which the distances between the first-1 spacer 411 to the first-4 spacer 414 are all the same or substantially the same as the first distance D1 is mainly described in more detail hereinafter, but the present disclosure is not limited thereto.

Referring to FIG. 11, the second spacer group may be arranged in the supplementary area SA defined in the adjacent area AA. The supplementary area SA may be defined in various suitable shapes to overlap with the first connection wire 60, as described above. The second spacer group may include the second spacers 510 arranged in the supplementary area SA and forming a pattern. The second spacers 510 may include a second-1 spacer 511, a second-2 spacer 512, a second-3 spacer 513, and a second-4 spacer 514.

The second spacer group may be formed in the same process as that of the first spacer group. In more detail, the second spacer 510 may include the same material as that of the first spacer 410. Furthermore, the second spacer 510 and the first spacer 410 may be arranged at (e.g., in or on) the same layer as each other, for example, such as on the pixel defining layer 118.

The second spacer group may be formed in the same or substantially the same pattern as that of the first spacer group. The second spacer group being formed in the same or substantially the same pattern as that of the first spacer group may mean that the sizes and shapes of the first spacer 410 and the second spacer 510 are the same or substantially the same as each other, and that the distance and arrangement between the first spacers 410 are the same or substantially the same as those of the second spacers 510. For example, the sizes and shapes of the first-1 spacer 411 and the second-1 spacer 511 may be the same or substantially the same as each other. Furthermore, the first distance D1 between the first-1 spacer 411 and the first-2 spacer 412 may be the same or substantially the same as a second distance D2 between the second-1 spacer 511 and the second-2 spacer 512.

Accordingly, the second spacer group may be easily arranged above the first connection wire 60. In other words, as the pattern of the second spacer group is formed to be the same or substantially the same as that of the first spacer group arranged in the display area DA, the arrangement design and the arrangement process thereof may be simplified.

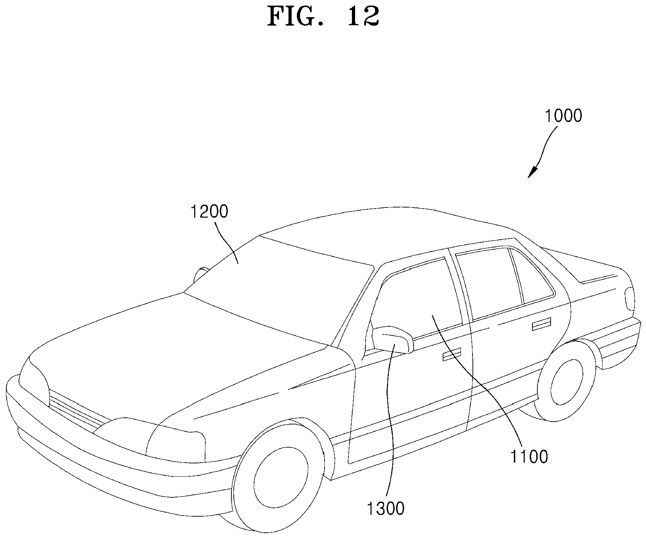

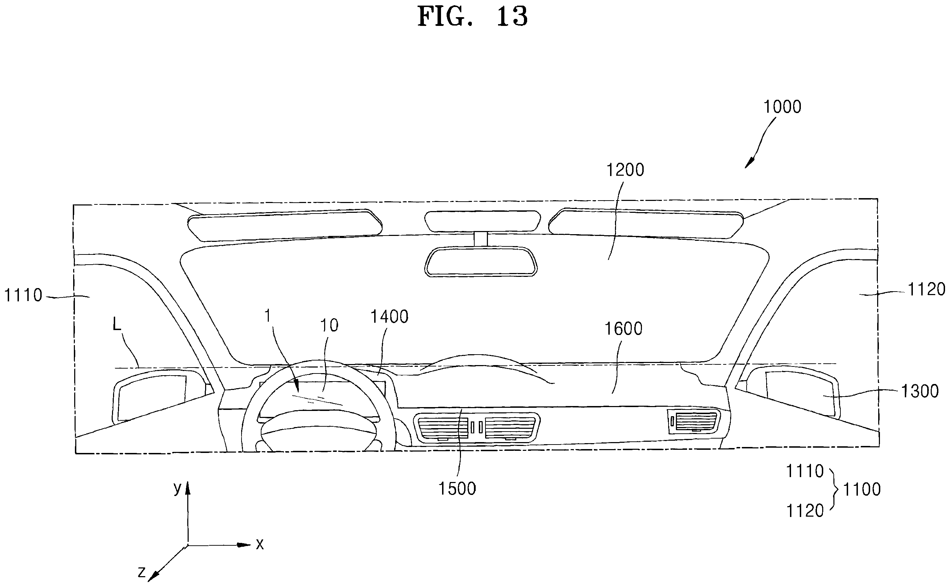

FIGS. 12 through 15 illustrate various products to which the display apparatus 1 is applied. FIG. 12 is a schematic perspective view of an exterior of a vehicle 1000. FIG. 13 is a schematic perspective view of an interior of the vehicle 1000.

Referring to FIGS. 12 and 13, the vehicle 1000 may refer to various devices that move various objects, such as humans, objects, or animals, from a starting point to a destination. The vehicle 1000 may drive on roads or tracks. The vehicle 1000 may move in a certain direction according to rotation of at least one wheel. For example, the vehicle 1000 may include a three-wheeled or four-wheeled vehicle, a construction machine, a two-wheeled vehicle, a motor vehicle, a bicycle, and/or a train running on a track. However, the vehicle 1000 is not necessarily limited to anything moved by the rotation of wheels, and may refer to any and all suitable transport means that may be moved by an electromagnetic force without including wheels.

The vehicle 1000 may include a body having an interior and an exterior, and a chassis, as a part except for the body, on which mechanical devices used for driving are installed. The exterior of the body may include a front panel, a bonnet, a roof panel, a rear panel, a trunk, and a pillar provided at a boundary between doors. The chassis of the vehicle 1000 may include a power generating device, a power transmission device, a driving device, a steering device, a braking device, a suspension device, a transmission device, a fuel device, front and rear wheels, and the like.

The vehicle 1000 may include side window glass 1100, front window glass 1200, a side mirror 1300, an instrument cluster 1400, a center fascia 1500, a passenger seat dashboard 1600, and the display apparatus 1.

The side window glass 1100 and the front window glass 1200 may be sectioned by a pillar arranged between the side window glass 1100 and the front window glass 1200.

The side window glass 1100 may be installed on a side surface of the vehicle 1000. The side window glass 1100 may be installed in the door of the vehicle 1000. The side window glass 1100 may be provided in a plurality to face each other. The side window glass 1100 may include first side window glass 1110 and second side window glass 1120. The first side window glass 1110 may be arranged adjacent to the instrument cluster 1400. The second side window glass 1120 may be arranged adjacent to the passenger seat dashboard 1600.

The side window glass 1100 may be spaced apart from each other in the x direction or the -x direction. For example, the first side window glass 1110 and the second side window glass 1120 may be spaced apart from each other in the x direction or the -x direction. In other words, a virtual straight line L connecting the side window glass 1100 may extend in the x direction or the -x direction. For example, the virtual straight line L connecting the first side window glass 1110 with the second side window glass 1120 may extend in the x direction or the -x direction.

The front window glass 1200 may be installed in the front of the vehicle 1000. The front window glass 1200 may be arranged between the side window glass 1100 facing each other.

The side mirror 1300 may provide a rear view of the vehicle 1000. The side mirror 1300 may be installed on the exterior of the body. The side mirror 1300 may be provided in a plurality. Any one of the side mirrors 1300 may be arranged outside the first side window glass 1110. The other one of the side mirrors 1300 may be arranged outside the second side window glass 1120.

The instrument cluster (panel) 1400 may be located behind the steering wheel (at the driver side). The instrument cluster 1400 may include a tachometer, a speedometer, a coolant thermometer, a fuel gauge, a direction conversion indicator, a high beam indicator, a warning light, a safety belt warning light, an odometer, a tachograph, an automatic transmission selection lever indicator, a door open warning light, an engine oil warning light, and/or a low fuel warning light.

The center fascia 1500 may include a control panel with multiple buttons for adjusting an audio system, an air conditioning system, and a seat heater. The center fascia 1500 may be arranged at one side of the instrument cluster 1400.

The passenger seat dashboard 1600 may be apart from the instrument cluster 1400 with the center fascia 1500 therebetween. The instrument cluster 1400 may be arranged corresponding to a driver seat (not shown), and the passenger seat dashboard 1600 may be arranged corresponding to a passenger seat (not shown). The instrument cluster 1400 may be adjacent to the first side window glass 1110, and the passenger seat dashboard 1600 may be adjacent to the second side window glass 1120.

The display apparatus 1 may display an image such as a video or a still image. The display apparatus 1 may arranged inside the vehicle 1000. The display apparatus 1 may be arranged between the side window glass 1100 facing each other. The display apparatus 1 may be arranged in at least any one of the instrument cluster 1400, the center fascia 1500, and the passenger seat dashboard 1600. FIG. 13 illustrates an example in which the display apparatus 1 is arranged in the instrument cluster 1400. In this case, the display apparatus 1 may be the display apparatus 1 described above.

In more detail, the display apparatus 1 may be arranged in the instrument cluster 1400, and may display driving information and the like. For example, the display apparatus 1 may display various pieces of driving information, such as speed and driving distance, various gauges such as fuel amount and temperature, and warning lights.

As another example, the display apparatus 1 may be arranged in the center fascia 1500 to display navigation information. Furthermore, the display apparatus 1 may be arranged in the center fascia 1500 to display information about audio, video, and vehicle settings.

As another example, the display apparatus 1 may be arranged in the passenger seat dashboard 1600 to display an image. For example, the image may be driving information and/or navigation information as described above, or an image for entertainment.

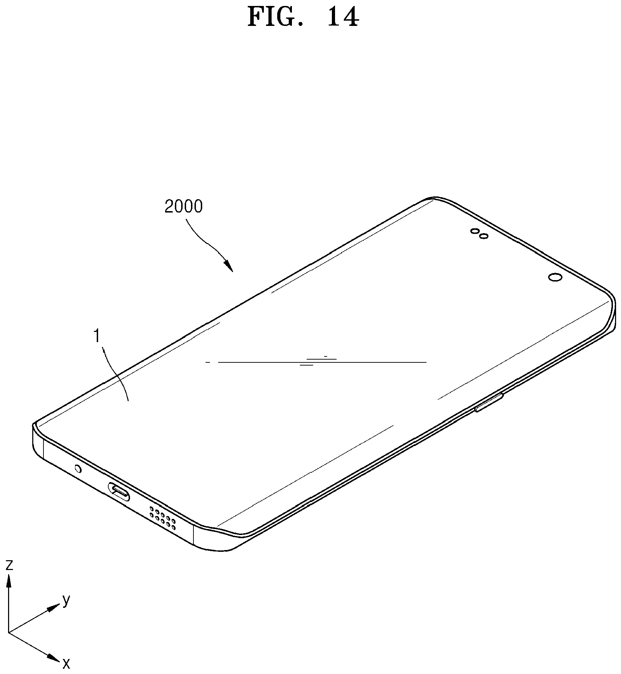

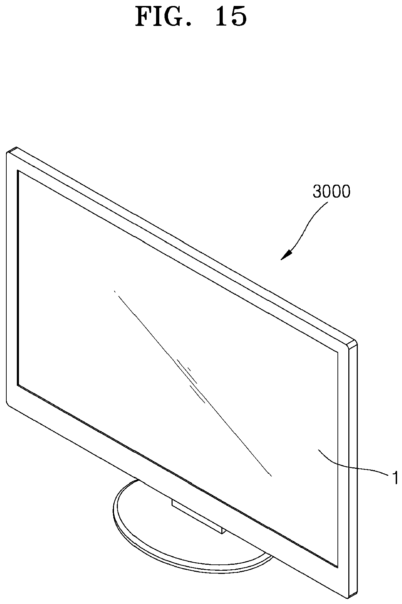

Referring to FIGS. 14 and 15, the display apparatus 1 may be provided in an electronic apparatus, such as a portable electronic apparatus 2000 or a monitor 3000, to display an image. However, the present disclosure is not limited thereto, and the display apparatus 1 may be used as a display screen not only for a portable electronic apparatus, such as a mobile phone, a smart phone, a tablet personal computer (PC), a mobile communication terminal, an electronic organizer, an electronic book, a portable multimedia player (PMP), a navigation device, an ultra-mobile PC (UMPC), and the like, but also for various electronic apparatuses, such as a television, a notebook computer, a monitor, a billboard, an internet of things (IOT) device, and the like. Furthermore, the display apparatus 1 may be used for a wearable device, such as a smart watch, a watch phone, a glasses type display, and a head mounted display (HMD).

According to one or more embodiments of the present disclosure, a display apparatus may be provided in which delamination of various layers may be prevented or substantially prevented, particularly in a peripheral area, and a vehicle including the display apparatus may be provided.

The foregoing is illustrative of some embodiments of the present disclosure, and is not to be construed as limiting thereof. Although some erwqs have been described, those skilled in the art will readily appreciate that various modifications are possible in the embodiments without departing from the scope of the present invention as defined by the claims. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present invention as defined in the appended claims.

## Claims

1. A display apparatus comprising:
a substrate comprising:
a display area (DA) comprising a plurality of pixels;
a pad area (PDA) at one side of the display area; and
an adjacent area (AA) between the display area and the pad area;
a first connection wire (60) above the substrate in the adjacent area, and configured to transmit a driving voltage from the pad area to the plurality of pixels in the display area;
a first spacer group adjacent to the plurality of pixels in the display area; and
a second spacer group above the first connection wire in a supplementary area (SA),
wherein the supplementary area (SA) is defined within a perimeter of the first connection wire (60) to overlap with the first connection wire in a plan view.

2. The display apparatus of claim 1, wherein the supplementary area has a closed loop shape along the perimeter of the first connection wire in a plan view.

3. The display apparatus of claim 1 or 2, wherein the supplementary area extends in a first direction, and comprises a plurality of line shapes spaced from each other in a second direction crossing the first direction in a plan view.

4. The display apparatus of claim 1, 2 or 3, wherein the first connection wire comprises:
a first wire portion in the adjacent area; and
a second wire portion extending from the first wire portion toward the pad area, and
wherein the supplementary area is located at a boundary between the first wire portion and the second wire portion in a plan view.

5. The display apparatus of any one of the preceding claims, further comprising:
an encapsulation substrate covering the display area and the adjacent area; and
a sealing member surrounding the display area, and sealing between the substrate and the encapsulation substrate,
wherein the supplementary area is located between one side of the display area and the sealing member in a plan view.

6. The display apparatus of claim 5, wherein the distance from the encapsulation substrate to an upper surface of the first spacer group is the same as the distance from the encapsulation substrate to an upper surface of the second spacer group.

7. The display apparatus of any one of the preceding claims, wherein the distance from an upper surface of the substrate to an upper surface of the first spacer group is the same as the distance from the upper surface of the substrate to an upper surface of the second spacer group.

8. The display apparatus of any one of the preceding claims, wherein the second spacer group comprises a single second spacer covering the supplementary area.

9. The display apparatus of any one of claims 1 to 7, wherein the second spacer group comprises a plurality of second spacers forming a pattern in the supplementary area.

10. The display apparatus of claim 9, wherein:
the first spacer group comprises a plurality of first spacers surrounding at least one of the plurality of pixels, and spaced from each other by a first distance,
the plurality of second spacers are spaced from each other by a second distance, and
the first distance is the same as the second distance.

11. The display apparatus of claim 10, wherein each of the plurality of first spacers is the same size as each of the plurality of second spacers.

12. The display apparatus of claim 10, wherein each of the plurality of first spacers has the same shape as each of the plurality of second spacers.

13. The display apparatus of any one of the preceding claims, wherein the first spacer group and the second spacer group comprise the same material.

14. The display apparatus of any one of the preceding claims, further comprising a pixel defining layer covering the substrate in the display area and the adjacent area, and having an opening defining an emission area of a corresponding one of the plurality of pixels,
wherein the first spacer group and the second spacer group are located on the pixel defining layer.

15. A vehicle comprising:
a body forming an exterior of the vehicle;
an instrument cluster;
a center fascia at one side of the instrument cluster; and
a dashboard spaced from the instrument cluster with the center fascia therebetween,
the vehicle further comprising a display apparatus according to any one of the preceding claims located in at least one of the instrument cluster, the center fascia, or the dashboard.
